# EUROPEAN PATENT APPLICATION

(11) **EP 1 548 075 A2**
(43) Date of publication of application: **29.06.2005**
(21) Application number: 04256560.6
(22) Date of filing: 25.10.2004
(51) Int. Cl.: C09G 1/02, H01L 21/321

(54) **Compositons and methods for barrier removal**

(30) Priority: 06.11.2003 US 704058
(71) Applicant: Rohm and Haas Electronic Materials CMP Holdings, Inc., Wilmington, DE 19899 (US)
(72) Inventor: Bian, Jinru, Newark, 19713 (US)
(74) Representative: Buckley, Guy Julian

(57) **Abstract**

The present invention provides an aqueous composition useful for polishing a semiconductor wafer, the wafer comprising a tantalum barrier material in the presence of a dielectric and an interconnect metal. The composition comprises an azole compound having a concentration sufficient to accelerate removal of the tantalum barrier material. In addition, the azole compound does not inhibit removal of the interconnect metal. The composition further comprises an abrasive. Also, the composition has a greater selectivity of the tantalum barrier material relative to the dielectric.

## Description

### BACKGROUND OF THE INVENTION

The invention relates to chemical mechanical planarization (CMP) of semiconductor wafer materials and, more particularly, to CMP compositions and methods for removing barrier materials of semiconductor wafers in the presence of dielectrics and interconnect metals.

Typically, a semiconductor wafer has a wafer of silicon and a dielectric layer containing multiple trenches arranged to form a pattern for circuit interconnects within the dielectric layer. The pattern arrangements usually have a damascene structure or dual damascene structure. A barrier layer covers the patterned dielectric layer and a metal layer covers the barrier layer. The metal layer has at least sufficient thickness to fill the patterned trenches with metal to form circuit interconnects.

CMP processes often include multiple planarization steps. For example, a first step removes a metal layer from underlying barrier dielectric layers. The first step polishing removes the metal layer, while leaving a smooth planar surface on the wafer with metal-filled trenches that provide circuit interconnects planar to the polished surface. First step polishing removes excess interconnect metals, such as copper at an initial high rate. After the first step removal, the second step polishing can remove a barrier that remains on the semiconductor wafer. This second step polishing removes the barrier from an underlying dielectric layer of a semiconductor wafer to provide a planar polished surface on the dielectric layer.

Unfortunately, CMP processes often result in the excess removal of unwanted metal from circuit interconnects, a condition known as "dishing". This dishing can result from, both first step polishing, and second step polishing. Dishing in excess of acceptable levels causes dimensional losses in the circuit interconnects. These "thin" areas in the circuit interconnects attenuate electrical signals and impair continued fabrication of dual damascene structures.

A barrier typically is a metal, metal alloy or intermetallic compound, such as tantalum or tantalum nitride. The barrier forms a layer that prevents migration or diffusion between layers within a wafer. For example, barriers prevent the diffusion of interconnect metal such as copper or silver into an adjacent dielectric. Barrier materials must be resistant to corrosion by most acids, and thereby, resist dissolution in a fluid polishing composition for CMP. Furthermore, these barrier materials may exhibit a toughness that resists removal by abrasive particles in a CMP slurry and from fixed abrasive pads.

Erosion refers to unwanted recesses in the surface of dielectric layers that result from removing some of the dielectric layer by the CMP process. Erosion that occurs adjacent to the metal in trenches causes dimensional defects in the circuit interconnects. These defects contribute to attenuation of electrical signals transmitted by the circuit interconnects and impair subsequent fabrication of a dual damascene structures in a manner similar to dishing. The removal rate of the barrier, versus, a removal rate of the metal interconnect or the dielectric layer is known as the selectivity ratio.

As discussed above, most barrier materials are difficult to remove by CMP, because the barrier materials resist removal by abrasion and by dissolution. Typical barrier removal slurries require a high abrasive concentration in a fluid polishing composition to remove a barrier material. For example, Farkas et al., in U.S. Pat. No. 6,001,730, disclose slurries for polishing copper interconnects having barrier layers with up to 12 weight percent of an abrasive. But slurries having these high abrasive concentrations tend to provide detrimental erosion to the dielectric layer and result in dishing and scratching of the copper interconnect. In addition to this, high abrasive concentrations can result in peeling or delaminating of low-k dielectric layers from semiconductor wafers.

Hence, what is needed is an improved CMP composition and method for selectively removing tantalum barrier materials. In particular, there is a need for a CMP composition and method for selectively removing tantalum barrier materials with reduced dielectric erosion and reduced dishing and scratching of the metal interconnect. Furthermore, there is a desire to remove tantalum barrier materials without peeling low-k dielectric layers from semiconductor wafers.

### STATEMENT OF THE INVENTION

The present invention provides an aqueous composition useful for polishing tantalum barrier material from a semiconductor wafer. The composition comprises an azole compound having a concentration sufficient to accelerate removal of the tantalum barrier material. In addition, the azole compound does not inhibit removal of the interconnect metal. The composition further comprises an abrasive. Also, the composition has a greater selectivity for the tantalum barrier material relative to the dielectric.

In a first aspect, the present invention provides an aqueous composition useful for polishing a semiconductor wafer, the wafer comprising a tantalum barrier material in the presence of a dielectric and an interconnect metal, the composition comprising: an azole compound having a concentration sufficient to accelerate removal of the tantalum barrier material, the azole compound not inhibiting removal of the interconnect metal; an abrasive; and wherein the composition has a greater selectivity of the tantalum barrier material relative to the dielectric.

In a second aspect, the present invention provides an aqueous composition useful for polishing tantalum barrier material from a semiconductor wafer, comprising by weight percent 0 to 25 oxidizer, 0 to 6 inhibitor for a nonferrous metal, 0 to 15 complexing agent for the nonferrous metal, 0.05 to 25 azole compound, 0.05 to 10 abrasive, wherein the composition has a selectivity of the tantalum barrier material relative to a dielectric of at least 10 to 1 as measured with a microporous polyurethane polishing pad pressure measured normal to a wafer of 20.7 kPa and the azole compound is selected from the group comprising, 1,2,4-triazole, 3-methyl-1,2,4-triazole, 3,5-dimethyl-1,2,4-triazole, 1-amino-1,2,4-triazole, 3-amino-1,2,4-triazole, 5-amino-3-methyl-1,2,4-triazole, 3-isopropyl-1,2,4-triazole, 1,2,3-triazole, 1-methyl-1,2,3-triazole, 1-amino-1,2,3-triazole, 1-amino-5-methyl-1,2,3-triazole, 4,5-dimethyl-1,2,3-triazole, 1-amino-5-n-propyl-1,2,3-triazole, 1-(β-aminoethyl)-1,2,3-triazole, 1-methyltetrazole, 2-methyltetrazole, 5-amino-1H-tetrazole, 5-amino-1-methyltetrazole, 1-(β-aminoethyl)tetrazole, a substituted triazole or tetrazole compound having an electron-donating substituent, and a mixture thereof.

In a third aspect, the present invention provides a chemical mechanical planarization method for polishing a semiconductor wafer, the wafer comprising a tantalum barrier material in the presence of a dielectric and an interconnect metal, the method comprising: contacting the wafer with a polishing composition, the polishing composition containing an azole compound and an abrasive, the azole compound having a concentration sufficient to accelerate removal of the tantalum barrier material, the azole compound not inhibiting removal of the interconnect metal; and polishing the wafer with a polishing pad to remove the tantalum barrier material at a removal rate greater than a removal rate for the dielectric as expressed in angstroms per minute.

### DETAILED DESCRIPTION

The solution and method provide unexpected selectivity for removing tantalum barrier materials. The solution relies upon an azole compound an abrasive to selectively remove tantalum barrier materials. The solution selectively removes barrier materials with reduced dielectric erosion and reduced dishing and scratching of the metal interconnects, such as copper. Furthermore, the solution removes tantalum barrier materials without peeling or delaminating low-k dielectric layers from semiconductor wafers.

For purposes of this specification, tantalum barrier refers to tantalum, tantalum-containing alloy, tantalum-base alloys and tantalum intermetallics. The solution has particular effectiveness for tantalum, tantalum-base alloys and tantalum intemetallics, such as tantalum carbides, nitrides and oxides. The slurry is most effective for accelerating the removal of tantalum barriers from patterned semiconductor wafers without inhibiting the removal rate of metal interconnects.

The azole compound is defined herein as a compound containing two or more nitrogen atoms in a conjugated cyclic compound. The conjugated cyclic compound further comprises at least one double bond between the at least two nitrogen atoms. The nitrogen atoms in the conjugated cyclic compound may be adjacent to each other or may be separated by other atoms. Also, the azole compound may be substituted by other groups along the cyclic ring members. The preferred substituting groups are electron donating groups. For purposes of the specification, the term "electron-donating" refers to a chemical group bonded to a substance that transfers electron density to that substance. F.A. Carey and R.J. Sundberg, in *Advanced Organic Chemistry, Part A: Structure and Mechanisms, 3*^{*rd*} *Edition* New York: Plenum Press (1990), p. 208 and 546-561 provide a more detailed description of electron-donating substituents. Electron-donating substituents include, for example, amino, hydroxyl (-OH), alkyl, substituted alkyl, hydrocabon radical, substituted hydrocarbon radical, amido, and aryl. These electron-donating substituents accelerate removal of tantalum-containing barrier materials. In theory, when the azole compound is adsorbed onto the barrier surface, such as TaN or Ta, the electrons flow between the at least two nitrogen atoms through the conjugate bonds. Consequently, the azole compounds have a strong affinity to the barrier surface. This affinity for the barrier surface is theorized to accelerate the barrier removal rate with limited use of abrasives.

Preferred azole compounds include, triazole compounds, for example, 1,2,4-triazole, 3-methyl-1,2,4-triazole, 3,5-dimethyl-1,2,4-triazole, 1-amino-1,2,4-triazole, 3-amino-1,2,4-triazole, 5-amino-3-methyl-1,2,4-triazole, 3-isopropyl-1,2,4-triazole, 1,2,3-triazole, 1-methyl-1,2,3-triazole, 1-amino-1,2,3-triazole, 1-amino-5-methyl-1,2,3-triazole, 4,5-dimethyl-1,2,3-triazole, 1-amino-5-n-propyl-1,2,3-triazole, 1-(β-aminoethyl)-1,2,3-triazole, a substituted triazole compound having an electron-donating substituent, and mixtures thereof. Further, other azole compounds include, tetrazole compounds, for example, 1-methyltetrazole, 2-methyltetrazole, 5-amino-1H-tetrazole, 5-amino-1-methyltetrazole, 1-(β-aminoethyl)tetrazole, a substituted tetrazole compound having an electron-donating substituent, and mixtures thereof. Particularly effective azole compounds for accelerating the removal of tantalum barriers are 1,2,4-triazole and 3-amino-1,2,4-triazole.

Advantageously, the azole compound may be present in the solution in a range of concentrations, for example from 0.05 to 25 weight percent. This specification expresses all concentrations in weight percent. A single type of azole compound may be present, or a mixture of azole compounds may be used. Most advantageously, the solution contains 0.1 to 10 weight percent azole compounds and for most applications, azole compound concentrations of 1 to 5 weight percent provide sufficient barrier removal rates. Most preferably, the concentration of the azole compound is 2 weight percent.

The polishing composition contains 0.05 to 10 weight percent abrasive to facilitate barrier layer. Within this range, it is desirable to have the abrasive present in an amount of greater than or equal to 0.1 weight percent, and preferably greater than or equal to 0.5 weight percent. Also, desirable within this range is an amount of less than or equal to 5 weight percent, and preferably less than or equal to 3 weight percent. Most preferably, the abrasive concentration is from 1 to 2 weight percent.

The abrasive has an average particle size of less than or equal to 50 nanometers (nm) for preventing excessive metal dishing and dielectric erosion. For purposes of this specification, particle size refers to the average particle size of the abrasive. More preferably, it is desirable to use a colloidal abrasive having an average particle size of less than or equal to 40 nm. Further, minimal dielectric erosion and metal dishing advantageously occurs with colloidal silica having an average particle size of less than or equal to 30 nm. Decreasing the size of the colloidal abrasive to less than or equal to 30 nm, tends to improve the selectivity of the polishing composition, but, it also tends to decrease the barrier removal rate. In addition, the preferred colloidal abrasive may include additives, such as dispersants, surfactants and buffers to improve the stability of the colloidal abrasive. One such colloidal abrasive is colloidal silica from Clariant S.A., of Puteaux, France.

The polishing composition includes the abrasive for "mechanical" removal of barrier layers. Example abrasives include inorganic oxides, metal borides, metal carbides, metal nitrides, polymer particles and mixtures comprising at least one of the foregoing. Suitable inorganic oxides include, for example, silica (SiO₂), alumina (Al₂O₃), zirconia (ZrO₂), ceria (CeO₂), manganese oxide (MnO₂), or combinations comprising at least one of the foregoing oxides. Modified forms of these inorganic oxides, such as, polymer-coated inorganic oxide particles and inorganic coated particles may also be utilized if desired. Suitable metal carbides, boride and nitrides include, for example, silicon carbide, silicon nitride, silicon carbonitride (SiCN), boron carbide, tungsten carbide, zirconium carbide, aluminum boride, tantalum carbide, titanium carbide, or combinations comprising at least one of the foregoing metal carbides, boride and nitrides. Diamond may also be utilized as an abrasive if desired. Alternative abrasives also include polymeric particles and coated polymeric particles. The preferred abrasive is silica.

Advantageously, the use of the azole compound facilitates polishing with low abrasive concentrations. The polishing solutions containing azole compounds and low abrasive concentrations can readily remove the tantalum barrier material at a rate of at least 10 times greater than the dielectric removal rate as expressed in angstroms per minute. More preferably, the solution of the present invention can readily remove the tantalum barrier material at a rate of at least 100 times greater than the dielectric removal rate. Most preferably, the solution of the present invention can readily remove the tantalum barrier material at a rate of at least 1000 times greater than the dielectric removal rate. Further, the polishing solutions containing azole compounds and low abrasive concentrations can readily remove the tantalum barrier material at a rate of at least 2 times greater than the metal removal rate as expressed in angstroms per minute. More preferably, the polishing solutions of the present invention can readily remove the tantalum barrier material at a rate of at least 5 times greater than the metal removal rate as expressed in angstroms per minute. Most preferably, the polishing solutions of the present invention can readily remove the tantalum barrier material at a rate of at least 10 times greater than the metal removal rate as expressed in angstroms per minute. Note, the azole compounds of the present invention accelerate the removal of the tantalum barrier material. The azole compounds of the present invention are not inhibitors for the interconnect metal. In other words, the azole compounds of the present invention accelerate the removal rate of the tantalum barrier material without inhibiting removal of the interconnect metal.

The azole compounds provide efficacy over a broad pH range in solutions containing a balance of water. This solution's useful pH range extends from at least 2 to 13. In addition, the solution advantageously relies upon a balance of deionized water to limit incidental impurities. The pH of the polishing fluid of this invention is preferably from 7 to 12, more preferably from pH 8-10. If the solution's pH is less than 7, an oxidizer may be added to enhance the azole efficacy for removing the barrier material. The bases used to adjust the pH of the slurry of this invention may be a base containing ammonium ion, such as ammonium hydroxide, bases containing alkyl-substituted ammonium ions, bases containing alkali metal ion, bases containing alkali-earth metal ion, bases containing group IIIB metal ion, bases containing group IVB metal ion, bases containing group VB metal ion and salts containing transition metal ion. The designed pH in the basic range is not only for removal of the barrier surface, but also helpful for the slurry of this invention to be stable. For the polishing slurry, the pH may be adjusted by a known technique. For example, an alkali may be directly added to a slurry in which a silica abrasive is dispersed and an organic acid is dissolved. Alternatively, a part or all of an alkali to be added may be added as an organic alkali salt. Examples of an alkali, which may be used, include alkali metal hydroxides such as potassium hydroxide, alkali metal carbonates such as potassium carbonate, ammonia and amines.

Optionally, the solution contains 0 to 25 weight percent oxidizer. A dvantageously, the optional oxidizer is in the range of 0 to 15 weight percent. The oxidizer is particularly effective at assisting the solution in removing tantalum oxide films that can form at low pH ranges. The oxidizing agent can be at least one of a number of oxidizing compounds, such as hydrogen peroxide (H₂O₂), monopersulfates, iodates, magnesium perphthalate, peracetic acid and other per-acids, persulfates, bromates, periodates, nitrates, iron salts, cerium salts, Mn (III), Mn (IV) and Mn (VI) salts, silver salts, copper salts, chromium salts, cobalt salts, halogens hypochlorites and a mixture thereof. Furthermore, it is often advantageous to use a mixture of oxidizer compounds. When the polishing slurry contains an unstable oxidizing agent such as, hydrogen peroxide, it is often most advantageous to mix the oxidizer into the slurry at the point of use.

Optionally, the solution contains 0 to 6 weight percent inhibitor to control interconnect removal rate by static etch or other removal mechanism. Adjusting the concentration of an inhibitor adjusts the interconnect metal removal rate by protecting the metal from static etch. Advantageously, the solution contains an optional 0.02 to 5 weight percent inhibitor for inhibiting static etch of copper or silver interconnects. The inhibitor may consist of a mixture of inhibitors. Azole inhibitors are particularly effective for copper and silver interconnects. Typical azole inhibitors include benzotriazole (BTA), mercaptobenzothiazole (MBT), tolytriazole and imidazole. BTA is a particularly effective inhibitor for copper and silver. Note, these inhibitors are specifically excluded from the definition of "azole" compounds for the purposes of this application. In other words, the azole compounds of the present invention are chosen for their selective ability to remove barrier materials and not for the purposes of inhibiting the removal rate of metal interconnects.

In addition to the inhibitor, the solution may contain 0 to 20 weight percent complexing agent for the nonferrous metal. The complexing agent, when present, prevents precipitation of the metal ions formed by dissolving the nonferrous metal interconnects. Most advantageously, the solution contains 0 to 10 weight percent complexing agent for the nonferrous metal. Example complexing agents include acetic acid, citric acid, ethyl acetoacetate, glycolic acid, lactic acid, malic acid, oxalic acid, salicylic acid, sodium diethyl dithiocarbamate, succinic acid, tartaric acid, thioglycolic acid, glycine, alanine, aspartic acid, ethylene diamine, trimethyl diamine, malonic acid, gluteric acid, 3-hydroxybutyric acid, propionic acid, phthalic acid, isophthalic acid, 3-hydroxy salicylic acid, 3,5-dihydroxy salicylic acid, gallic acid, gluconic acid, pyrocatechol, pyrogallol, tannic acid, including, salts and mixtures thereof. Advantageously, the complexing agent is selected from the group consisting of acetic acid, citric acid, ethyl acetoacetate, glycolic acid, lactic acid, malic acid, oxalic acid and mixtures thereof. Most advantageously, the complexing agent is citric acid.

The polishing fluid of the present invention is applicable to any semiconductor substrate containing a conductive metal, such as copper, aluminum, tungsten, platinum, palladium, gold, or iridium; a barrier or liner film, such as tantalum, tantalum nitride, titanium, or titanium nitride; and an underlying dielectric layer. For purposes of the specification, the term dielectric refers to a semi-conducting material of dielectric constant, k, which includes low-k and ultra-low k dielectric materials. The present methods removes tantalum barrier materials with little effect on conventional dielectrics and low-k dielectric materials. Since the solutions provide effective barrier removal rates with low concentrations of abrasives at low pressures (i.e., less than 20.7 kPa) and high tantalum selectivity, it facilitates polishing with low dielectric erosion rates. The solution and method are excellent for preventing erosion of multiple wafer constituents, for example, porous and nonporous low-k dielectrics, organic and inorganic low-k dielectrics, organic silicate glasses (OSG), fluorosilicate glass (FSG), carbon doped oxide (CDO), tetraethylorthosilicate (TEOS) and a silica derived from TEOS.

The polishing solution may also include levelers such as, ammonium chloride, to control surface finish of the interconnect metal. In addition to this, the solution optionally may contain a biocide for limiting biological contamination. For example, Kordek® MLX microbicide 2-Methyl-4-isothiazolin-3-one in water (Rohm and Haas Company) provides an effective biocide for many applications. The biocide is typically used in the concentration prescribed by the supplier.

The solution provides a tantalum nitride to dielectric and metal selectivity of at least 10 to 1 and at least 2 to 1, respectively, as measured with a microporous polyurethane polishing pad pressure measured normal to a wafer of 20.7 kPa. A particular polishing pad useful for determining selectivity is the Politex microporous polyurethane polishing pad. Adjusting the abrasive and azole compound concentrations adjusts the tantalum barrier removal rate. Adjusting the inhibitor, oxidizer, complexing agent and leveler concentrations adjusts the etch rate of the interconnect metals.

### Examples

In the Examples, numerals represent examples of the invention and letters represent comparative examples. In addition, all example solutions contained 0.01 weight percent Kordek® MLX microbicide 2-Methyl-4-isothiazolin-3-one in water and 0.01 ammonium chloride brightener.

### Example 1

This experiment measured removal rates of the TaN barrier, a dielectric layer of TEOS and copper from a semiconductor wafer. In particular, the test determined the effect of specific azole compounds and abrasives in a second step polishing operation. A Strausbaugh polishing machine using a Politex polyurethane polishing pad (Rodel, Inc.) under downforce conditions of about 3 psi (20.7 kPa) and a polishing solution flow rate of 200 cc/min, a platen speed of 120 RPM and a carrier speed of 114 RPM planarized the samples. The polishing solutions had a pH of 9 adjusted with KOH and HNO₃. All solutions contained deionized water. In addition, polishing solutions included 1 weight percent silica abrasives having an average particle size of 50 nm.

**Table 1**

| Second Polishing Step Results | | | | | | | | |
|---|---|---|---|---|---|---|---|---|
| Test | Additive | Wt.% | Abrasive (wt.%) | BTA (wt.%) | Citric Acid (wt. %) | TaN Å/min | TEOS Å/min | Cu Å/min |
| A | None | -- | 0 | 0.1 | 0 | 6 | -3 | 38 |
| B | None | -- | 1 | 0 | 0.15 | 26 | 32 | 116 |
| C | None | -- | 1 | 0.2 | 0.15 | 163 | 39 | 91 |
| D | 1,2,4-triazole | 2 0 | | 0.1 | 0 | -8 | -1.4 | 33 |
| E | 3-amino-1,2,4-triazole | 2 | 0 | 0.1 | 0 | -21 | -5.1 | 49 |
| 1 | 1,2,4-triazole | 2 | 1 | 0.1 | 0 | 1995 | -0.2 | 135 |
| 2 | 3-amino-1,2,4-triazole | 2 | 2 | 0.1 | 0 | 2223 | -0.4 | 174 |

As illustrated in Table 1, high removal rates of the TaN barrier film are obtained with a polishing fluid that includes an azole compound and an abrasive. In particular, second polishing step fluids containing an abrasive and 1,2,4-triazole or 3-amino-1,2,4-triazole (Tests 1 and 2, respectively) provided excellent removal rates for the TaN, namely, at least 1995 angstroms per minute (Å/min). Polishing fluids containing an abrasive without an azole compound (Comparative Solutions, B and C) and polishing fluids containing an azole compound without an abrasive (Comparative Solutions, D and E) showed lower rates of TaN removal and poor removal selectivity relative to the dielectric (TEOS) and to the metal (Cu). Note, the negative removal rates of the TaN and the dielectric are within the defined tolerances of the polishing machine and indicate no detectable TaN and/or TEOS loss. When an azole compound was present in the polishing fluid with an abrasive, the removal selectivity of the TaN relative to the dielectric was 1995 to 1 and 2223 to 1, for Tests 1 and 2, respectively. The removal selectivity of the TaN to the metal was 15 to 1 and 13 to 1, for Tests 1 and 2, respectively. Note, the selectivity discussed is at the test conditions for the Example as defined above. The selectivity may vary with changes made to the test parameters.

The results shown in Table 1 indicates that excellent removal of the barrier film (TaN) along with commensurate removal selectivity relative the metal film (Cu) and the dielectric layer (TEOS) is obtained when using polishing fluids containing azole compounds and an abrasive. An azole compound present at about 2 weight percent was useful for this removal, providing an excellent barrier removal rate and removal selectivity. All of the polishing fluids contained an abrasives content of 1 to 2 weight percent, an amount that is well below the abrasives concentration typically used in conventional second polishing step fluids.

The solution and method provide excellent selectivity for removing tantalum barrier materials such as tantalum, tantalum nitride and tantalum oxide. The solution selectively removes tantalum barrier materials with reduced dielectric erosion. For example, the solution can remove tantalum barriers without a detectable TEOS loss and without peeling or delaminating low-k dielectric layers. In addition, the solution reduces dishing and scratching of copper interconnects. Also, the azole compounds of the present invention accelerate the removal of the tantalum barrier material without inhibiting removal of the interconnect metal.

## Claims

1. An aqueous composition useful for polishing a semiconductor wafer, the wafer comprising a tantalum barrier material in the presence of a dielectric and an interconnect metal, the composition comprising:
an azole compound having a concentration sufficient to accelerate removal of the tantalum barrier material, the azole compound not inhibiting removal of the interconnect metal;
an abrasive; and
wherein the composition has a greater selectivity of the tantalum barrier material relative to the dielectric.

2. The composition of claim 1 wherein the concentration is 0.05 to 25 weight percent of the azole compound.

3. The composition of claim 1 wherein the composition comprises 0.05 to 10 weight percent of the abrasive.

4. The composition of claim 1 wherein the composition has a selectivity of the tantalum barrier material relative to a metal of at least 2 to 1 as measured with a microporous polyurethane polishing pad pressure measured normal to a wafer of 20.7 kPa.

5. The composition of claim 1 wherein the azole compound is selected from the group comprising: triazole, tetrazole, and a mixture thereof.

6. The composition of claim 5 wherein the triazole is selected from the group comprising: 1,2,4-triazole, 3-methyl-1,2,4-triazole, 3,5-dimethyl-1,2,4-triazole, 1-amino-1,2,4-triazole, 3-amino-1,2,4-triazole, 5-amino-3-methyl-1,2,4-triazole, 3-isopropyl-1,2,4-triazole, 1,2,3-triazole, 1-methyl-1,2,3-triazole, 1-amino-1,2,3-triazole, 1-amino-5-methyl-1,2,3-triazole, 4,5-dimethyl-1,2,3-triazole, 1-amino-5-n-propyl-1,2,3-triazole, 1-(β-aminoethyl)-1,2,3-triazole, a substituted triazole compound having an electron-donating substituent, and a mixture thereof.

7. The composition of claim 5 wherein the tetrazole is selected from the group comprising: 1-methyltetrazole, 2-methyltetrazole, 5-amino-1H-tetrazole, 5-amino-1-methyltetrazole, 1-(β-aminoethyl)tetrazole, a substituted tetrazole compound having an electron-donating substituent, and a mixture thereof.

8. An aqueous composition useful for polishing tantalum barrier material from a semiconductor wafer, comprising by weight percent 0 to 25 oxidizer, 0 to 6 inhibitor for a nonferrous metal, 0 to 15 complexing agent for the nonferrous metal, 0.05 to 25 azole compound, 0.05 to 12 abrasive, wherein the composition has a selectivity of the tantalum barrier material relative to a dielectric of at least 10 to 1 as measured with a microporous polyurethane polishing pad pressure measured normal to a wafer of 20.7 kPa and the azole compound is selected from the group comprising, 1,2,4-triazole, 3-methyl-1,2,4-triazole, 3,5-dimethyl-1,2,4-triazole, 1-amino-1,2,4-triazole, 3-amino-1,2,4-triazole, 5-amino-3-methyl-1,2,4-triazole, 3-isopropyl-1,2,4-triazole, 1,2,3-triazole, 1-methyl-1,2,3-triazole, 1-amino-1,2,3-triazole, 1-amino-5-methyl-1,2,3-triazole, 4,5-dimethyl-1,2,3-triazole, 1-amino-5-n-propyl-1,2,3-triazole, 1-(β-aminoethyl)-1,2,3-triazole, 1-methyltetrazole, 2-methyltetrazole, 5-amino-1H-tetrazole, 5-amino-1-methyltetrazole, 1-(β-aminoethyl)tetrazole, a substituted triazole or tetrazole compound having an electron-donating substituent, and a mixture thereof.

9. A chemical mechanical planarization method for polishing a semiconductor wafer, the wafer comprising a tantalum barrier material in the presence of a dielectric and an interconnect metal, the method comprising:
contacting the wafer with a polishing composition, the polishing composition containing an azole compound and an abrasive, the azole compound having a concentration sufficient to accelerate removal of the tantalum barrier material, the azole compound not inhibiting removal of the interconnect metal; and
polishing the wafer with a polishing pad to remove the tantalum barrier material at a removal rate greater than a removal rate for the dielectric as expressed in angstroms per minute.

10. The method of claim 9 wherein the azole compound is selected from the group comprising: 1,2,4-triazole, 3-methyl-1,2,4-triazole, 3,5-dimethyl-1,2,4-triazole, 1-amino-1,2,4-triazole, 3-amino-1,2,4-triazole, 5-amino-3-methyl-1,2,4-triazole, 3-isopropyl-1,2,4-triazole, 1,2,3-triazole, 1-methyl-1,2,3-triazole, 1-amino-1,2,3-triazole, 1-amino-5-methyl-1,2,3-triazole, 4,5-dimethyl-1,2,3-triazole, 1-amino-5-n-propyl-1,2,3-triazole, 1-(β-aminoethyl)-1,2,3-triazole, 1-methyltetrazole, 2-methyltetrazole, 5-amino-1H-tetrazole, 5-amino-1-methyltetrazole, 1-(β-aminoethyl)tetrazole, a substituted triazole or tetrazole compound having an electron-donating substituent, and a mixture thereof.
